# EUROPÄISCHE PATENTANMELDUNG

(11) **EP 2 009 698 A2**
(43) Veröffentlichungstag der Anmeldung: **31.12.2008**
(21) Anmeldenummer: 08006529.5
(22) Anmeldetag: 31.03.2008
(51) Int. Cl.: H01L 27/148

(54) **Halbleiterdetektor zur Strahlungsdetektion und zugehöriges Betriebsverfahren**

(30) Priorität: 28.06.2007 DE 102007029898
(71) Anmelder: Max-Planck-Gesellschaft zur Förderung der Wissenschaften e.V., 80539 München (DE); PNSensor GmbH, 80803 München (DE)
(72) Erfinder: Strüder, Lothar, Prof. Dr., 80803 München (DE); Lutz, Gerhard, Dr., 81739 München (DE); Holl, Peter, 80798 München (DE)
(74) Vertreter: Beier, Ralph

(57) **Zusammenfassung**

Die Erfindung betrifft einen Halbleiterdetektor, insbesondere einen pnCCD-Detektor, zur Strahlungsdetektion, mit einem Guard-Ring (12, 14) und einer innerhalb des Guard-Rings (12, 14) angeordneten Auslese-Anode (3, 4) zum Auslesen von strahlungsgenerierten Signalladungsträgern (e⁻) sowie mit einem außerhalb des Guard-Rings (12, 14) angeordneten Lösch-Kontakt (9) zum Entfernen der angesammelten Signalladungsträger (e⁻) von der Auslese-Anode (3, 4). Erfindungsgemäß umfasst der Halbleiterdetektor weiterhin eine Unterbrechung (15, 16) in dem Guard-Ring (12, 14) sowie ein steuerbares Gate (17, 18), das über der Unterbrechung (15, 16) in dem Guard-Ring (12, 14) angeordnet ist und die Unterbrechung (15, 16) in dem Guard-Ring (12, 14) in Abhängigkeit von einer elektrischen Ansteuerung des Gates (17, 18) für die zu entfernenden Signalladungsträger (e⁻) durchlässig oder undurchlässig macht.

## Beschreibung

Die Erfindung betrifft einen Halbleiterdetektor zur Strahlungsdetektion sowie ein zugehöriges Betriebsverfahren gemäß den nebengeordneten Ansprüchen.

Aus Gerhard Lutz: "Semiconductor Radiation Detectors", 2. Auflage 2001, Springer-Verlag, Seite 144-152 sind pnCCD-Detektoren bekannt, bei denen die einfallende Strahlung in einer pnCCD-Struktur Signalelektronen generiert, die entlang der pnCCD-Struktur zu einer Auslese-Anode transportiert werden. Derartige pnCCD-Detektoren auf hochohmigem n-dotiertem Silizium haben eine Reife erlangt, die nah an die physikalischen Grenzen heran reicht. So liegt das Rauschen der besten pnCCD-Detektoren bei lediglich 1,5 Elektronen bei einem Leistungsverbrauch von ca. 0,3mW pro Kanal.

Dieses gute Rauschverhalten lässt sich bei den herkömmlichen pnCCD-Detektoren durch einen kapazitätsfreien Löschmechanismus erreichen, der beispielsweise in Carlo Fiorini, Peter Lechner: "Continous Charge Restoration in Semiconductor Detectors by Means of the Gate-to-Drain Current of the Integrated Front-End JFET", IEEE Transactions on Nuclear Science, Vol. 46, No. 3, Juni 1999, Seite 761-764 beschrieben ist. Bei diesem Löschmechanismus wird die Auslese-Anode des pnCCD-Detektors durch einen sogenannten "Weak Avalanche"-Prozess mittels eines JFET-Transistors (JFET: Junction Field Effect Transistor) wieder auf ihr ursprüngliches Potential zurückgeführt. Dieser herkömmliche Löschmechanismus ist jedoch zum Löschen großer Signalladungsmengen ungeeignet. Darüber hinaus erlaubt dieser herkömmliche Löschmechanismus kein schnelles Löschen der Signalladungen im Nanosekundenbereich.

Aus Pinotti, E. et al.: "The pn-CCD on-chip electronics", Nuclear Instruments and Methods in Physics Research A326 (1993) 85-91 ist ein anderer Löschmechanismus für einen pnCCD-Detektor bekannt, bei dem die Signalladungsträger von einem integrierten Feldeffekttransistor von der Auslese-Anode des pnCCD-Detektors entfernt werden. Dieser Löschmechanismus beeinflusst jedoch nachteilig die Kapazität der Auslese-Anode.

Der Erfindung liegt deshalb die Aufgabe zugrunde, einen Halbleiterdetektor mit einem verbesserten Löschmechanismus zu schaffen und ein entsprechend verbessertes Betriebsverfahren für einen derartigen Halbleiterdetektor anzugeben. Hierbei sollte der erfindungsgemäße Löschmechanismus vorzugsweise kapazitätsfrei sein und ein schnelles Löschen von großen Signalladungsmengen im Nanosekundenbereich ermöglichen.

Diese Aufgabe wird durch einen erfindungsgemäßen Halbleiterdetektor bzw. ein entsprechendes Betriebsverfahren gemäß den nebengeordneten Ansprüchen gelöst.

Bei dem erfindungsgemäßen Halbleiterdetektor weist der Löschmechanismus einen Guard-Ring auf, der eine Auslese-Anode umgibt, wobei die Auslese-Anode in herkömmlicher Weise zum Auslesen von strahlungsgenerierten Signalladungsträgern dient. Weiterhin umfasst der erfindungsgemäße Löschmechanismus einen Lösch-Kontakt, der außerhalb des Guard-Rings angeordnet ist und in herkömmlicher Weise zum Entfernen der angesammelten Signalladungsträger von der Auslese-Anode dient, um die Auslese-Anode wieder auf ihr ursprüngliches elektrisches Potential zurückzuführen. Im Gegensatz zu den herkömmlichen pnCCD-Detektoren mit einem die Auslese-Anode umgebenden Guard-Ring ist der Guard-Ring bei dem erfindungsgemäßen Halbleiterdetektor jedoch nicht ringförmig geschlossen, sondern weist eine Unterbrechung auf. Über der Unterbrechung in dem Guard-Ring ist erfindungsgemäß ein steuerbares Gerät angeordnet, das die Unterbrechung in dem Guard-Ring in Abhängigkeit von einer elektrischen Ansteuerung des Gates für die zu entfernenden Signalladungsträger durchlässig oder undurchlässig macht.

Der im Rahmen der Erfindung verwendete Begriff eines Guard-Rings ist nicht auf ringförmige Strukturen im engeren geometrischen Sinne beschränkt, die kreisrund oder oval sind. Vielmehr kann der Guard-Ring bei dem erfindungsgemäßen Halbleiterdetektor auch rechteckig sein oder die Form eines Polygonzugs haben, um nur einige Beispiele zu nennen. Vorzugsweise handelt sich jedoch bei dem Guard-Ring um eine dotierte Implantation in einem Halbleitersubstrat, wobei die Implantation des Guard-Rings die Auslese-Anode umgibt.

Im Folgenden wird die elektrische Ansteuerung des Gates über der Unterbrechung in dem Guard-Ring für den Fall exemplarisch beschrieben, dass der Guard-Ring p-dotiert ist, während die Auslese-Anode n-dotiert ist.

In einem Auslesemodus wird das Gate über der Unterbrechung in dem Guard-Ring dann so angesteuert, dass die Unterbrechung für die Signalladungsträger undurchlässig ist. Hierzu wird bei der vorstehend genannten Dotierung eine negative Spannung an das Gate über der Unterbrechung angelegt, wodurch in der Unterbrechung des Guard-Rings eine Löcher-Inversionsschicht erzeugt wird, welche die Auslese-Anode von dem Lösch-Kontakt elektrisch isoliert. In dem Auslesemodus kann der Lösch-Kontakt also keine Signalladungsträger von der Auslese-Anode abführen.

In einem Reset- oder Lösch-Modus wird das Gate über der Unterbrechung in dem Guard-Ring dagegen so angesteuert, dass die Unterbrechung für die zu entfernenden Signalladungsträger durchlässig ist, so dass der Lösch-Kontakt die Signalladungsträger von der Auslese-Anode entfernen kann. Hierzu wird bei der vorstehend genannten Dotierung eine positive elektrische Spannung an das Gate über der Unterbrechung in dem Guard-Ring angelegt, wodurch in der Unterbrechung in dem Guard-Ring eine Elektronen-Akkumulationsschicht erzeugt wird, die einen elektrisch leitenden Durchgriff von dem Lösch-Kontakt zu der Auslese-Anode bewirkt.

In einem bevorzugten Ausführungsbeispiel der Erfindung weist der Halbleiterdetektor mehrere Auslese-Anoden auf, die beispielsweise jeweils einer Detektorzeile oder einer Detektorspalte zugeordnet sein können. Die einzelnen Auslese-Anoden sind hierbei jeweils innerhalb eines Guard-Rings angeordnet, wobei die einzelnen Guard-Ringe jeweils eine Unterbrechung aufweisen, die durch jeweils ein steuerbares Gate für die Signalladungsträger durchlässig oder undurchlässig gemacht werden kann.

Bei diesem Ausführungsbeispiel mit mehreren Auslese-Anoden ist vorzugsweise ein Lösch-Kontakt für die Entfernung der Signalladungsträger von mehreren Auslese-Anoden zuständig. Beispielsweise kann zwischen zwei benachbarten Auslese-Anoden ein Lösch-Kontakt angeordnet sein, der die Signalladungsträger von den beiden angrenzenden Auslese-Anoden entfernt. Hierbei sind die Unterbrechungen in den beiden Guard-Ringen vorzugsweise dem in der Mitte befindlichen Lösch-Kontakt zugewandt, um die Löschung der Signalladungsträger zu erleichtern.

Bei dem vorstehend beschriebenen Ausführungsbeispiel mit mehreren unterbrochenen Guard-Ringen und mehreren zugehörigen Gates sind die einzelnen Gates vorzugsweise gemeinsam elektrisch kontaktiert und liegen dementsprechend auf dem selben Potential. Die Unterbrechungen in den einzelnen Guard-Ringen können also durch eine gemeinsame Ansteuerung der zugehörigen Gates durch ein gemeinsames Steuersignal für die Signalladungsträger durchlässig oder undurchlässig gemacht werden. Die Erfindung umfasst deshalb auch eine zugehörige Steuereinheit zur elektrischen Ansteuerung des Gates über der Unterbrechung in dem Guard-Ring sowie zur Ansteuerung des Lösch-Kontakts.

In einer Variante der Erfindung steuert diese Steuereinheit sowohl das Gate über der Unterbrechung in dem Guard-Ring als auch den Lösch-Kontakt mit einem Gleichspannungssignal an.

In einer anderen Variante der Erfindung steuert die Steuereinheit dagegen sowohl das Gate über der Unterbrechung in dem Guard-Ring als auch den Lösch-Kontakt mit einem Wechselspannungssignal an.

Weiterhin sieht eine Variante der Erfindung vor, dass die Steuereinheit den Lösch-Kontakt mit einem Gleichspannungssignal ansteuert, wohingegen die Steuereinheit das Gate über der Unterbrechung in dem Guard-Ring mit einem Wechselspannungssignal ansteuert.

Ferner ist in einer weiteren Variante der Erfindung vorgesehen, dass die Steuereinheit den Lösch-Kontakt mit einem Wechselspannungssignal ansteuert, wohingegen die Steuereinheit das Gate über der Unterbrechung in dem Guard-Ring mit einem Gleichspannungssignal ansteuert.

Vorteilhaft an dem vorstehend beschriebenen erfindungsgemäßen Löschmechanismus ist die kurze Löschdauer, die benötigt wird, um die angesammelten strahlungsgenerierten Signalladungsträger nahezu vollständig von der Auslese-Anode zu entfernen, sofern man von Ladungsträgern absieht, die durch Rauschen verursacht werden. So ist die erforderliche Löschdauer bei dem erfindungsgemäßen Löschmechanismus vorzugsweise kürzer als 100ns, 50ns, 30ns, 20ns, 10ns oder sogar kürzer als 5ns. Während der Löschdauer wird das Gate über der Unterbrechung in dem Guard-Ring so angesteuert, dass die Unterbrechung für die Signalladungsträger durchlässig ist. Darüber hinaus wird der Lösch-Kontakt während der Löschdauer so angesteuert, dass die Signalladungsträger von der Auslese-Anode entfernt werden und durch die Unterbrechung in dem Guard-Ring hindurch zu dem Lösch-Kontakt gelangen.

Ein weiterer Vorteil des erfindungsgemäßen Löschmechanismus besteht darin, dass keine Streukapazität auf den Eingangsknoten eines Source-Follower-Verstärkers eingeprägt wird.

Vorteilhaft an dem erfindungsgemäßen Löschmechanismus ist weiterhin die Tatsache, dass die Verlustleistung eines verstärkenden JFETs nicht beeinflusst wird.

Weiterhin umfasst der erfindungsgemäße Halbleiterdetektor vorzugsweise mehrere CCD-Bildzellenreihen (CCD: Charge Coupled Device) mit jeweils mehreren hintereinander angeordneten Bildzellen, wobei die einfallende Strahlung in den einzelnen Bildzellen Signalladungsträger erzeugt, die entlang den CCD-Bildzellenreihen weiter transportiert werden, wobei am Ende der CCD-Bildzellenreihen jeweils eine Auslese-Anode angeordnet ist. Derartige CCD-Detektoren sind an sich bekannt und beispielsweise in dem bereits eingangs zitierten Fachbuch Gerhard Lutz: "Semiconductor Radiation Detectors", 2. Auflage 2001, Springer-Verlag, Seite 137-152 beschrieben, das der vorliegenden Beschreibung hinsichtlich des Aufbaus und der Funktionsweise von CCD-Detektoren in vollem Umfang zuzurechnen ist, so dass an dieser Stelle auf eine detaillierte Beschreibung von CCD-Detektoren verzichtet werden kann. Die einzelnen CCD-Bildzellenreihen können hierbei jeweils in Transportkanäle münden, in denen die strahlungsgenerierten Signalladungsträger weiter transportiert werden.

Darüber hinaus umfasst der erfindungsgemäße Halbleiterdetektor vorzugsweise einen Verstärker, der mit der Auslese-Anode verbunden ist, wobei der Verstärker wahlweise auf dem Halbleitersubstrat des Halbleiterdetektors integriert oder als separates Bauelement ausgeführt sein kann.

Bei dem erfindungsgemäßen Halbleiterdetektor bildet das Gate über der Unterbrechung in dem Guard-Ring also zusammen mit der Auslese-Anode und dem Löschkontakt einen MOSFET-Transistor mit der Auslese-Anode als Source und dem Lösch-Kontakt als Drain sowie der Unterbrechung in dem Guard-Ring als steuerbarem Leitungskanal.

Der MOSFET-Transistor kann hierbei wahlweise selbstsperrend oder selbstleitend ausgeführt sein.

Weiterhin kann es sich bei dem MOSFET-Transistor wahlweise um einen n-Kanal-MOSFET-Transistor oder um einen p-Kanal-MOSFET-Transistor handeln.

Ferner ist zu erwähnen, dass die Auslese-Anode, der Guard-Ring, der Lösch-Kontakt und das Gate über der Unterbrechung in dem Guard-Ring in der praktischen Realisierung an einer Oberfläche eines Halbleitersubstrats angeordnet sind.

Der Lösch-Kontakt, das Halbleitersubstrat und die Auslese-Anode sind hierbei entsprechend einem ersten Dotierungstyp dotiert, während der Guard-Ring entsprechend einem zweiten Dotierungstyp dotiert sind.

Bei dem ersten Dotierungstyp kann es sich im Rahmen der Erfindung um eine n-Dotierung handeln, während der zweite Dotierungstyp eine p-Dotierung sein kann.

Es ist jedoch im Rahmen der Erfindung alternativ auch möglich, dass der erste Dotierungstyp eine p-Dotierung ist, während der zweite Dotierungstyp eine n-Dotierung ist. In diesem Fall müssen die vorstehend erwähnten Spannungen zum Auslesen bzw. Löschen ebenfalls entsprechend invertiert werden.

Ferner ist zu erwähnen, dass der erfindungsgemäße Halbleiterdetektor vorzugsweise auf einem n-Typ-Halbleiter (z.B. Silizium) realisiert wird, wobei die Signalladungsträger Elektronen sind.

Es besteht jedoch alternativ auch die Möglichkeit einer Realisierung des erfindungsgemäßen Halbleiterdetektors auf einem p-Typ-Halbleiter, wobei die Signalladungsträger Löcher sind.

Neben dem vorstehend beschriebenen erfindungsgemäßen Halbleiterdetektor umfasst die Erfindung auch ein entsprechendes Betriebsverfahren, bei dem das Gate über der Unterbrechung in dem Guard-Ring entsprechend angesteuert wird, um die Unterbrechung für die zu entfernenden Signalladungsträger durchlässig oder undurchlässig zu machen, wie bereits vorstehend beschrieben wurde.

Ferner umfasst die Erfindung auch die neuartige Verwendung eines an sich bekannten MOSFET-Transistors zur Steuerung der Signalladungsträger-Durchlässigkeit einer Unterbrechung in einem Guard-Ring, der eine Auslese-Anode eines Halbleiterdetektors umgibt.

Schließlich ist noch zu erwähnen, dass sich der erfindungsgemäße Halbleiterdetektor nicht nur zur Detektion von Photonenstrahlung eignet, sondern allgemein die Detektion ionisierender Strahlung ermöglicht, die in dem Halbleiterdetektor Elektron-Loch-Paare und damit freie Signalladungsträger (Elektronen oder Löcher) erzeugt. Beispielsweise kann es sich bei der zu detektierenden Strahlung um Alphastrahlung, Betastrahlung, Gammastrahlung oder kosmische Strahlung handeln.

Andere vorteilhafte Weiterbildungen der Erfindung sind in den Unteransprüchen gekennzeichnet oder werden nachstehend zusammen mit der Beschreibung eines bevorzugten Ausführungsbeispiels der Erfindung anhand der Figuren näher erläutert. Es zeigen:

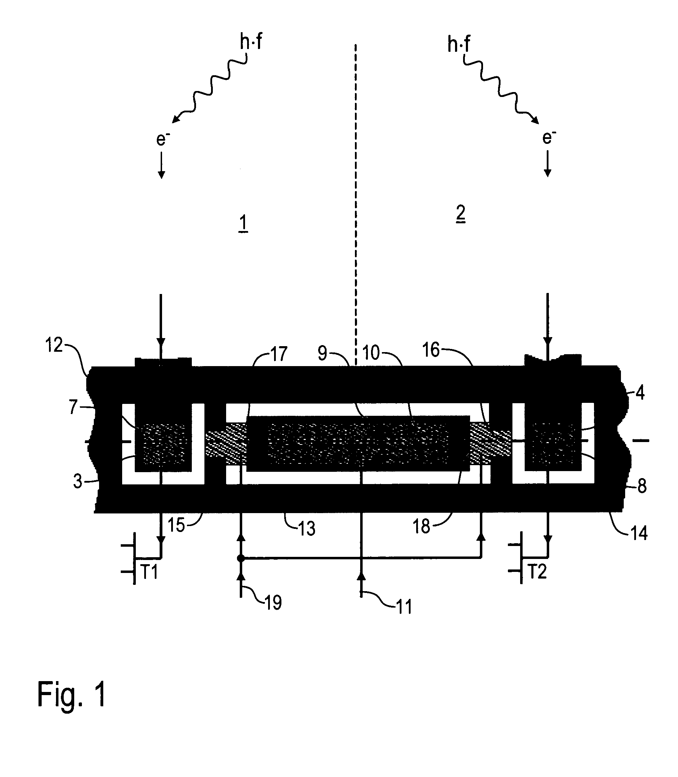

- Figur 1: eine Aufsicht auf einen Ausschnitt eines erfindungsgemäßen pnCCD-Halbleiterdetektors,
- Figur 2A: eine Perspektivansicht auf den pnCCD-Halbleiterdetektor gemäß Figur 1 in einem Auslesemodus, in dem die strahlungsgenerierten Signalladungsträger ausgelesen werden, sowie
- Figur 2B: eine Perspektivansicht des pnCCD-Halbleiterdetektors gemäß Figur 1 in einem Löschmodus, in dem die angesammelten Signalladungsträger gelöscht werden.

Die Figuren zeigen einen Ausschnitt eines pnCCD-Halbleiterdetektors mit mehreren parallel nebeneinander angeordneten Transportkanälen 1, 2, wobei die Transportkanäle 1, 2 in herkömmlicher Weise ausgeführt sein können und deshalb hier nur schematisch dargestellt sind. In den einzelnen Bildzellen der CCD-Bildzellenreihen erzeugt die einfallende Strahlung h·f Signalelektronen e⁻, die dann in herkömmlicher Weise in Pfeilrichtung entlang den Transportkanälen 1, 2 zu jeweils einer Auslese-Anode 3, 4 transportiert werden.

Die Auslese-Anoden 3, 4 bestehen im Wesentlichen aus einer n-dotierten Implantation an einer Oberseite eines n-dotierten Halbleitersubstrats 5, wobei das Halbleitersubstrat 5 an seiner Rückseite eine p-dotierte Rückelektrode 6 aufweist, um das Halbleitersubstrat 5 im Betrieb vollständig zu verarmen.

Weiterhin weisen die Auslese-Anoden 3, 4 an ihrer Oberseite jeweils einen Metallkontakt 7, 8 auf, über den die Auslese-Anoden 3, 4 mit jeweils einem Transistorverstärker T1, T2 verbunden sind, wobei die Transistorverstärker T1, T2 hier nur schematisch dargestellt sind und ebenfalls auf dem Halbleitersubstrat 5 als On-Chip-Verstärker integriert sein können.

Zwischen den beiden Auslese-Anoden 3, 4 ist ein gemeinsamer Lösch-Kontakt 9 angeordnet, der ebenfalls aus einer n-dotierten Implantation an der Oberseite des Halbleitersubstrats 5 besteht und an seiner Oberseite einen Metallkontakt 10 trägt, an den über eine Steuerleitung 11 eine Löschspannung angelegt werden kann, um die Signalelektronen e⁻ von den Auslese-Anoden 3, 4 zu entfernen.

Die Auslese-Anoden 3, 4 und der Lösch-Kontakt 9 sind jeweils von einem Guard-Ring 12, 13, 14 umgeben, wobei der Guard-Ring 12 die Auslese-Anode 3 umgibt, während der Guard-Ring 14 die Auslese-Anode 4 umgibt. Der Guard-Ring 13 umgibt dagegen den Lösch-Kontakt 9 und ist zwischen den beiden Guard-Ringen 12, 14 der Auslese-Anoden 3, 4 angeordnet, wobei die Guard-Ringe 12, 13, 14 durch eine gemeinsame p-dotierte Implantation an der Oberseite des Halbleitersubstrats 5 gebildet werden.

Der Guard-Ring 12 um die Auslese-Anode 3 weist auf der dem Lösch-Kontakt 9 zugewandten Seite eine Unterbrechung 15 auf, so dass der Guard-Ring 12 nicht vollständig geschlossen ist. Die Unterbrechung 15 in dem Guard-Ring 12 soll es hierbei ermöglichen, dass der Lösch-Kontakt 9 die Signalelektronen e⁻ von der Auslese-Anode 3 entfernt, wie noch detailliert beschrieben wird.

Der Guard-Ring 14 um die Auslese-Anode 4 weist ebenfalls eine Unterbrechung 16 auf der dem Lösch-Kontakt 9 zugewandten Seite auf, wobei die Unterbrechung 16 die gleiche Funktion hat wie die Unterbrechung 15 in dem Guard-Ring 12.

Über den beiden Unterbrechungen 15, 16 ist jeweils ein metallisches oder aus Polysilizium bestehendes Gate 17, 18 angeordnet, wobei die beiden Gates 17, 18 über eine gemeinsame Steuerleitung 19 angesteuert werden können, um die Durchlässigkeit der Unterbrechungen 15, 16 für die Signalelektronen e⁻ zu steuern, wie noch detailliert beschrieben wird.

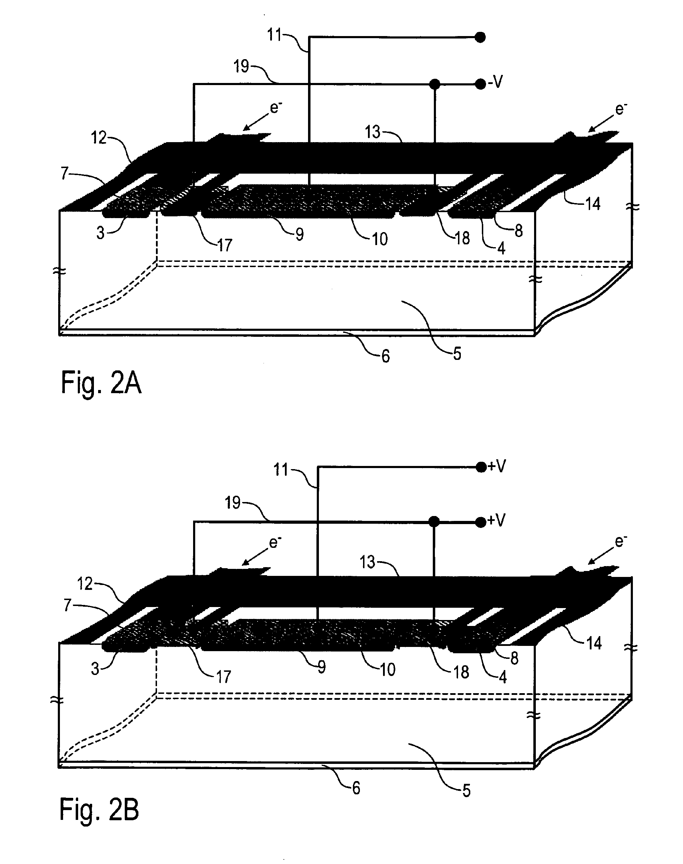

Im Folgenden wird nun unter Bezugnahme auf Figur 2A ein Auslesemodus des pnCCD-Halbleiterdetektors beschrieben, in dem über die Auslese-Anoden 3, 4 die strahlungsgenerierten Signalelektronen e⁻ von den Transistorverstärkern T1, T2 ausgelesen werden.

In dem Auslesemodus sollen die Unterbrechungen 15, 16 in den Guard-Ringen 12, 14 um die Auslese-Anoden 3, 4 für die Signalelektronen e⁻ undurchlässig sein, damit die strahlungsgenerierten Signalelektronen e⁻ vollständig zur Ansteuerung der Transistorverstärker T1, T2 beitragen.

Über die gemeinsame Steuerleitung 19 wird deshalb an die Gates 17, 18 über den Unterbrechungen 15, 16 in den Guard-Ringen 12, 14 eine negative Spannung -V angelegt, die in den Unterbrechungen 15, 16 eine Löcher-Inversionsschicht erzeugt und die Unterbrechungen 15, 16 dadurch elektrisch nicht leitend macht. In dem Auslesemodus ist der Lösch-Kontakt 9 also von den Auslese-Anoden 3, 4 elektrisch isoliert.

Im Folgenden wird nun unter Bezugnahme auf Figur 2B ein Lösch- oder Reset-Modus beschrieben, in dem über den Lösch-Kontakt 9 die angesammelten Signalelektronen e⁻ von den Auslese-Anoden 3, 4 entfernt werden, um die Auslese-Anoden 3, 4 wieder auf ihr ursprüngliches elektrisches Potential zurückzuführen.

Hierzu wird über die Steuerleitung 19 an die Gates 17, 18 über den Unterbrechungen 15, 16 in den Guard-Ringen 12, 14 eine positive elektrische Spannung +V angelegt, die in den Unterbrechungen 15, 16 eine Elektronen-Akkumulationsschicht erzeugt, was einen leitenden Durchgriff von dem Lösch-Kontakt 9 auf die Auslese-Anoden 3, 4 bewirkt, so dass die Signalelektronen e⁻ von den Auslese-Anoden 3, 4 über den gemeinsamen Lösch-Kontakt 9 abgeführt werden.

Hierzu wird in dem Lösch-Modus eine positive Löschspannung über die Steuerleitung 11 an den Löschkontakt 9 angelegt.

Die Erfindung ist nicht auf das vorstehend beschrieben bevorzugte Ausführungsbeispiel beschränkt. Vielmehr ist eine Vielzahl von Varianten und Abwandlungen möglich, die ebenfalls von dem Erfindungsgedanken Gebrauch machen und deshalb in den Schutzbereich fallen.

### Bezugszeichenliste:

- 1, 2: Transportkanäle
- 3, 4: Auslese-Anode
- 5: Halbleitersubstrat
- 6: Rückelektrode
- 7, 8: Metallkontakte
- 9: Lösch-Kontakt
- 10: Metallkontakt
- 11: Steuerleitung
- 12, 13, 14: Guard-Ringe
- 15, 16: Unterbrechung
- 17, 18: Gate
- 19: Steuerleitung
- T1, T2: Transistorverstärker

## Patentansprüche

1. Halbleiterdetektor, insbesondere pnCCD-Detektor, zur Strahlungsdetektion mit
a) einem Guard-Ring (12, 14),
b) einer innerhalb des Guard-Rings (12, 14) angeordneten Auslese-Anode (3, 4) zum Auslesen von strahlungsgenerierten Signalladungsträgern (e⁻), und
c) einem außerhalb des Guard-Rings (12, 14) angeordneten Lösch-Kontakt (9) zum Entfernen der angesammelten Signalladungsträger (e⁻) von der Auslese-Anode (3, 4),
**gekennzeichnet durch**
d) eine Unterbrechung (15, 16) in dem Guard-Ring (12, 14), und
e) ein steuerbares Gate (17, 18), das über der Unterbrechung (15, 16) in dem Guard-Ring (12, 14) angeordnet ist und die Unterbrechung (15, 16) in dem Guard-Ring (12, 14) in Abhängigkeit von einer elektrischen Ansteuerung des Gates (17, 18) für die zu entfernenden Signalladungsträger (e⁻) durchlässig oder undurchlässig macht.

2. Halbleiterdetektor nach Anspruch 1,
**gekennzeichnet durch**
a) mehrere Guard-Ringe (12, 14) mit jeweils einer Unterbrechung (15, 16),
b) mehrere Auslese-Anoden (3, 4), die in jeweils einem der Guard-Ringe (12, 14) angeordnet sind, und
c) mehrere steuerbare Gates (17, 18), die jeweils über den Unterbrechungen (15, 16) in den einzelnen Guard-Ringen (12, 14) angeordnet sind und die jeweilige Unterbrechung (15, 16) in Abhängigkeit von ihrer elektrischen Ansteuerung für die Signalladungsträger (e⁻) durchlässig oder undurchlässig machen.

3. Halbleiterdetektor nach Anspruch 2, **dadurch gekennzeichnet, dass** derselbe Lösch-Kontakt (9) die Signalladungsträger (e⁻) von mehreren Auslese-Anoden (3, 4) in benachbarten Guard-Ringen (12, 14) entfernen kann.

4. Halbleiterdetektor nach Anspruch 3,
**dadurch gekennzeichnet, dass**
a) der Lösch-Kontakt (9) zwischen zwei benachbarten Guard-Ringen (12, 14) angeordnet ist, und
b) die Unterbrechungen (15, 16) in den beiden benachbarten Guard-Ringen (12, 14) einander zugewandt sind.

5. Halbleiterdetektor nach einem der Ansprüche 2 bis 4, **dadurch gekennzeichnet, dass** die Gates (17, 18) gemeinsam elektrisch kontaktiert sind und auf demselben Potential liegen.

6. Halbleiterdetektor nach einem der vorhergehenden Ansprüche, **gekennzeichnet durch** eine Steuereinheit (11, 19) zur elektrischen Ansteuerung des Gates (17, 18) und des Lösch-Kontakts (9).

7. Halbleiterdetektor nach Anspruch 6, **dadurch gekennzeichnet, dass** die Steuereinheit (11, 19) das Gate (17, 18) und den Lösch-Kontakt (9) beide mit einem Gleichspannungssignal ansteuert.

8. Halbleiterdetektor nach Anspruch 6, **dadurch gekennzeichnet, dass** die Steuereinheit (11, 19) das Gate (17, 18) und den Lösch-Kontakt (9) beide mit einem Wechselspannungssignal ansteuert.

9. Halbleiterdetektor nach Anspruch 6, **dadurch gekennzeichnet, dass** die Steuereinheit (11, 19) den Lösch-Kontakt (9) mit einem Gleichspannungssignal und das Gate (17, 18) mit einem Wechselspannungssignal ansteuert.

10. Halbleiterdetektor nach Anspruch 6, **dadurch gekennzeichnet, dass** die Steuereinheit (11, 19) den Lösch-Kontakt (9) mit einem Wechselspannungssignal und das Gate (17, 18) mit einem Gleichspannungssignal ansteuert.

11. Halbleiterdetektor nach einem der vorhergehenden Ansprüche, **dadurch gekennzeichnet, dass**
a) zur nahezu vollständigen Entfernung der angesammelten strahlungsgenerierten Signalladungsträger (e⁻) von der Auslese-Anode (3, 4) eine bestimmte Löschdauer erforderlich ist, in der die Unterbrechung (15, 16) in dem Guard-Ring (12, 14) für die Signalladungsträger (e⁻) durchlässig ist, und
b) die erforderliche Löschdauer kürzer als 100ns, 50ns, 30ns, 20ns, 10ns oder 5ns ist.

12. Halbleiterdetektor nach einem der vorhergehenden Ansprüche, **gekennzeichnet durch** mehrere Transportkanäle (1, 2) zum Transport der strahlungsgenerierten Signalladungsträger (e⁻) zu den jeweiligen Auslese-Anoden (3, 4) am Ende der Transportkanäle (1, 2).

13. Halbleiterdetektor nach einem der vorhergehenden Ansprüche, **gekennzeichnet durch** einen Verstärker (T1, T2), der mit der Auslese-Anode (3, 4) verbunden ist.

14. Halbleiterdetektor nach einem der vorhergehenden Ansprüche, **dadurch gekennzeichnet, dass** das Gate (17, 18), die Auslese-Anode (3, 4) und der Lösch-Kontakt (9) einen MOSFET-Transistor bilden mit der Auslese-Anode (3, 4) als Source und dem Lösch-Kontakt (9) als Drain und der Unterbrechung (15, 16) in dem Guard-Ring (12, 14) als steuerbarem Kanal.

15. Halbleiterdetektor nach Anspruch 14, **dadurch gekennzeichnet, dass** der MOSFET-Transistor selbstsperrend oder selbstleitend ist.

16. Halbleiterdetektor nach Anspruch 14 oder 15, **dadurch gekennzeichnet, dass** der MOSFET-Transistor ein n-Kanal-MOSFET-Transistor oder ein p-Kanal-MOSFET-Transistor ist.

17. Halbleiterdetektor nach einem der vorhergehenden Ansprüche, **dadurch gekennzeichnet, dass** die Auslese-Anode (3, 4), der Guard-Ring (12, 14), der Lösch-Kontakt (9) und das Gate (17, 18) an einer Oberfläche eines Halbleitersubstrats (5) angeordnet sind.

18. Halbleiterdetektor nach einem der vorhergehenden Ansprüche, **dadurch gekennzeichnet,**
a) **dass** der Lösch-Kontakt (9), das Halbleitersubstrat (5) und die Auslese-Anode (3, 4) entsprechend einem ersten Dotierungstyp dotiert sind, und
b) **dass** der Guard-Ring (12, 14) entsprechend einem zweiten Dotierungstyp dotiert ist.

19. Halbleiterdetektor nach Anspruch 17, **dadurch gekennzeichnet, dass** der erste Dotierungstyp eine n-Dotierung aufweist, während der zweite Dotierungstyp eine p-Dotierung aufweist.

20. Halbleiterdetektor nach Anspruch 17, **dadurch gekennzeichnet, dass** der erste Dotierungstyp eine p-Dotierung aufweist, während der zweite Dotierungstyp eine n-Dotierung aufweist.

21. Betriebsverfahren für einen Halbleiterdetektor mit
a) einem Guard-Ring (12, 14),
b) einer innerhalb des Guard-Rings (12, 14) angeordneten Auslese-Anode (3, 4) zum Auslesen von strahlungsgenerierten Signalladungsträgern (e⁻) und
c) einem außerhalb des Guard-Rings (12, 14) angeordneten Lösch-Kontakt (9) zum Entfernen der angesammelten Signalladungsträger (e⁻) von der Auslese-Anode (3, 4),
**dadurch gekennzeichnet, dass**
d) der Guard-Ring (12, 14) eine Unterbrechung (15, 16) aufweist,
e) über der Unterbrechung (15, 16) in dem Guard-Ring (12, 14) ein Gate (17, 18) angeordnet ist, und
f) das Gate (17, 18) zum Entfernen der angesammelten Signalladungsträger (e⁻) mit einer Lösch-Spannung angesteuert wird, wobei die Lösch-Spannung die Unterbrechung (15, 16) in dem Guard-Ring (12, 14) für die zu entfernenden Signalladungsträger (e⁻) durchlässig macht.

22. Betriebsverfahren nach Anspruch 21, **dadurch gekennzeichnet, dass** die an dem Gate (17, 18) anliegende Lösch-Spannung in der Unterbrechung (15, 16) des Guard-Rings (12, 14) unter dem Gate (17, 18) eine leitende Akkumulationsschicht von Majoritätsladungsträgern erzeugt.

23. Betriebsverfahren nach Anspruch 21 oder 22,
**dadurch gekennzeichnet,**
a) **dass** das Halbleitersubstrat (5), die Auslese-Anode (3, 4) und der Lösch-Kontakt (9) entsprechend einem ersten Dotierungstyp dotiert sind, und
b) **dass** der Guard-Ring (12, 14) entsprechend einem zweiten Dotierungstyp dotiert ist, und
c) **dass** die an dem Gate (17, 18) anliegende Lösch-Spannung in der Unterbrechung (15, 16) des Guard-Rings (12, 14) einen leitenden Kanal entsprechend dem ersten Dotierungstyp erzeugt.

24. Betriebsverfahren nach einem der Ansprüche 21 bis 23,
**dadurch gekennzeichnet**,
a) dass zum Auslesen der angesammelten Signalladungsträger (e⁻) über die Auslese-Anode (3, 4) eine Auslese-Spannung an das Gate (17, 18) angelegt wird,
b) dass die an dem Gate (17, 18) anliegende Auslese-Spannung in der Unterbrechung (15, 16) des Guard-Rings (12, 14) eine sperrende Inversionsschicht von Minoritätsladungsträgern erzeugt.

25. Betriebsverfahren nach Anspruch 24,
**dadurch gekennzeichnet,**
a) **dass** die Auslese-Anode (3, 4), das Halbleitersubstrat (5) und der Lösch-Kontakt (9) entsprechend einem ersten Dotierungstyp dotiert sind, und
b) **dass** der Guard-Ring (12, 14) entsprechend einem zweiten Dotierungstyp dotiert ist, und
c) **dass** die Auslese-Spannung an dem Gate (17, 18) eine negative Spannung (-V) ist.

26. Betriebsverfahren nach einem der Ansprüche 21 bis 25,
**dadurch gekennzeichnet, dass** das Gate (17, 18) und der Lösch-Kontakt (9) beide mit einem Gleichspannungssignal angesteuert werden.

27. Betriebsverfahren nach einem der Ansprüche 21 bis 26,
**dadurch gekennzeichnet, dass** das Gate (17, 18) und der Lösch-Kontakt (9) beide mit einem Wechselspannungssignal angesteuert werden.

28. Betriebsverfahren nach einem der Ansprüche 21 bis 27,
**dadurch gekennzeichnet, dass**
a) der Lösch-Kontakt (9) mit einem Gleichspannungssignal angesteuert wird und
b) das Gate (17, 18) mit einem Wechselspannungssignal angesteuert wird.

29. Betriebsverfahren nach einem der Ansprüche 21 bis 28,
**dadurch gekennzeichnet, dass**
a) der Lösch-Kontakt (9) mit einem Wechselspannungssignal angesteuert wird und
b) das Gate (17, 18) mit einem Gleichspannungssignal angesteuert wird.

30. Betriebsverfahren nach einem der Ansprüche 21 bis 29,
**dadurch gekennzeichnet,**
a) **dass** die Lösch-Spannung jeweils nur für eine begrenzte Lösch-Dauer an das Gate (17, 18) angelegt wird,
b) **dass** innerhalb der Lösch-Dauer die angesammelten Signalladungsträger (e⁻) größtenteils von der Auslese-Anode (3, 4) entfernt werden, und
c) **dass** die Löschdauer kürzer als 100ns, 50ns, 30ns, 20ns, 10ns oder 5ns ist.

31. Betriebsverfahren nach einem der Ansprüche 23 bis 30,
**dadurch gekennzeichnet,**
a) **dass** der erste Dotierungstyp eine n-Dotierung aufweist,
b) **dass** der zweite Dotierungstyp eine p-Dotierung aufweist,
c) **dass** die Löschspannung eine positive Spannung ist, und
d) **dass** die Auslesespannung eine negative Spannung ist.

32. Betriebsverfahren nach einem der Ansprüche 23 bis 30,
**dadurch gekennzeichnet,**
a) **dass** der erste Dotierungstyp eine p-Dotierung aufweist,
b) **dass** der zweite Dotierungstyp eine n-Dotierung aufweist,
c) **dass** die Löschspannung eine negative Spannung ist, und
d) **dass** die Auslesespannung eine positive Spannung ist.

33. Verwendung eines MOSFET-Transistors zur Steuerung der Signalladungsträger-Durchlässigkeit einer Unterbrechung (15, 16) in einem Guard-Ring (12, 14) um eine Auslese-Anode (3, 4) eines Halbleiterdetektors für Signalladungsträger (e⁻).
